# EUROPEAN PATENT APPLICATION

(11) **EP 3 203 483 A1**
(43) Date of publication of application: **09.08.2017**
(21) Application number: 16837970.9
(22) Date of filing: 08.11.2016
(51) Int. Cl.: H01B 13/00, B21D 5/00, H01B 12/06, H01F 6/06

(54) **OXIDE SUPER-CONDUCTING WIRE PRODUCTION METHOD AND SUPER-CONDUCTING COIL PRODUCTION METHOD**

(30) Priority: 18.12.2015 JP 2015247834
(71) Applicant: Fujikura Ltd., Tokyo 135-8512 (JP)
(72) Inventor: OHSUGI, Masaki, Chiba 2858550 (JP)
(74) Representative: Cabinet Plasseraud
(86) International application number: PCT/JP2016/083069
(87) International publication number: WO 2017/104297

(57) **Abstract**

In a method of manufacturing an oxide superconducting wire, a superconducting laminated body is prepared, a tape-shaped stabilizer is folded to be divided into a first portion in which the stabilizer covers one surface of the superconducting laminated body in a thickness direction and a second portion in which the stabilizer covers both side surfaces of the superconducting laminated body in a widthwise direction and the stabilizer is disposed around the superconducting laminated body, the first portion is formed to have a width larger than that of the superconducting laminated body using a molding jig and the superconducting laminated body is covered with the stabilizer, and the superconducting laminated body and the stabilizer are bonded and a bonding material between the second portion and the superconducting laminated body is formed to have a thickness larger than that of a bonding material between the first portion and the superconducting laminated body.

## Description

### TECHNICAL FIELD

The present invention relates to a method of manufacturing an oxide superconducting wire and a method of manufacturing a superconducting coil.

Priority is claimed on Japanese Patent Application No. 2015-247834, filed December 18, 2015, the content of which is incorporated herein by reference.

### BACKGROUND ART

In recent years, development of a superconducting wire using a Bi-based superconducting body represented by a general formula of Bi₂Sr₂CaCu₂O_{8+δ} (Bi2212) or Bi₂Sr₂Ca₂Cu₃O_{10+δ} (Bi2223) or a rare-earth-element-based superconducting body represented by a general formula of REBa₂Cu₃O_{X} (RE123) has been performed. Further, the rare earth element RE is not limited to the case of Y, but the rare earth elements are frequently referred to as Y-based elements.

As one configuration of the rare-earth-element-based superconducting wire, a structure in which an oxide superconducting layer is deposited on a base material constituted by a metal tape or the like via an intermediate layer, a protective layer formed of Ag or the like configured to protect the oxide superconducting layer is then formed, and a stabilizer such as a metal foil or the like formed of Cu is further formed is known (for example, see Patent Document 1). The stabilizer is provided as a current path (path) configured to bypass overcurrent generated when the oxide superconducting layer is converted from a superconducting state to a normal conducting state due to any cause (upon quenching).

### PRIOR ART DOCUMENTS

### PATENT DOCUMENTS

[Patent Document 1] PCT International Publication No. WO2013/077387

### DISCLOSURE OF INVENTION

### PROBLEMS TO BE SOLVED BY THE INVENTION

In the superconducting wire having a layered structure, a ceramic material such as an oxide superconducting layer or the like and a metal material such as a metal tape or the like are compounded. For example, when a strong external force is applied to the superconducting wire due to an electromagnetic force upon electrical connection, thermal contraction such as that of an insulating material (resin) or the like around the wire, residual stress, or the like, exfoliation may occur between layers that constitute the superconducting wire. When breakage of the oxide superconducting layer or interlayer exfoliation between the oxide superconducting layer and an adjacent layer occurs, the function as the superconductor may be lost.

In consideration of the above-mentioned circumstances, the present invention is directed to provide a method of manufacturing an oxide superconducting wire and a method of manufacturing a superconducting coil, which are capable of improving the exfoliation strength of the superconducting wire.

### MEANS FOR SOLVING THE PROBLEMS

A first aspect of the present invention is a method of manufacturing an oxide superconducting wire, the method includes preparing a superconducting laminated body in which an intermediate layer and an oxide superconducting layer are sequentially deposited on a first surface of a tape-shaped base material and a protective layer configured to cover a surface of at least the oxide superconducting layer is formed; folding a tape-shaped stabilizer, dividing the stabilizer into a first portion in which the stabilizer covers one surface of the superconducting laminated body in a thickness direction and a second portion in which the stabilizer covers both side surfaces of the superconducting laminated body in a widthwise direction, and disposing the stabilizer around the superconducting laminated body; increasing the width of the first portion to be larger than the width of the superconducting laminated body using a molding jig to cover the superconducting laminated body with the stabilizer; and bonding the superconducting laminated body and the stabilizer and forming a bonding material between the second portion and the superconducting laminated body to have a thickness larger than that of a bonding material between the first portion and the superconducting laminated body.

According to a second aspect of the present invention, in the method of manufacturing the oxide superconducting wire of the first aspect, the molding jig may have a groove having a width larger than that of the superconducting laminated body, and fold the stabilizer along an inner surface of the groove.

According to a third aspect of the present invention, in the method of manufacturing the oxide superconducting wire according to the first or second aspect, the molding jig may have an area inserted between the side surface of the superconducting laminated body in the widthwise direction and the second portion of the stabilizer such that the width of the first portion is larger than that of the superconducting laminated body.

According to a fourth aspect of the present invention, in the method of manufacturing the oxide superconducting wire according to any one of the first to third aspects, when the superconducting laminated body is covered with the stabilizer, a solid bonding material may be disposed between the superconducting laminated body and the stabilizer.

According to a fifth aspect of the present invention, in the method of manufacturing the oxide superconducting wire according to the fourth aspect, at least some of the solid bonding material may be supplied between the superconducting laminated body and the stabilizer in a state in which the bonding material is separated from the superconducting laminated body and the stabilizer.

In addition, a sixth aspect of the present invention is a method of manufacturing a superconducting coil, the method includes manufacturing an oxide superconducting wire through the method of manufacturing the oxide superconducting wire according to any one of the first to fifth aspects; and manufacturing a superconducting coil using the oxide superconducting wire.

### EFFECTS OF THE INVENTION

According to the aspects of the present invention, an oxide superconducting wire in which a bonding material is filled between side surfaces and a stabilizer at both sides in a widthwise direction of a superconducting laminated body can be manufactured. Since an interface between an oxide superconducting layer and an adjacent layer is reinforced by the bonding material at end portions in the widthwise direction, exfoliation strength of the superconducting wire can be improved.

### BRIEF DESCRIPTION OF THE DRAWINGS

FIG. 1 is a cross-sectional view showing an example of a superconducting wire; and
FIG. 2 is a cross-sectional view showing an example of a process of covering a superconducting laminated body with a stabilizer.

### EMBODIMENTS FOR CARRYING OUT THE INVENTION

Hereinafter, a preferred embodiment of the present invention will be described with reference to the accompanying drawings.

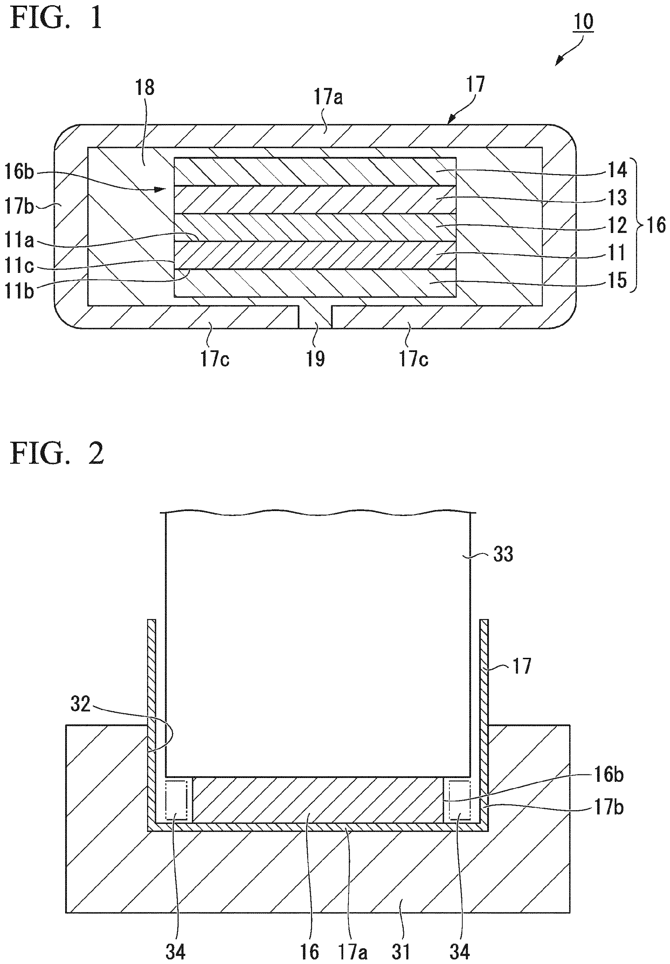

FIG. 1 shows a cross-sectional view of an example of a superconducting wire of an embodiment. The cross-sectional view schematically shows a structure having a cross section perpendicular to a longitudinal direction of the superconducting wire. A superconducting wire 10 includes a superconducting laminated body 16, a stabilizer 17 formed around the superconducting laminated body 16, and a bonding material 18 configured to bond together the superconducting laminated body 16 and the stabilizer 17.

The superconducting laminated body 16 shown in FIG. 1 has a configuration in which a tape-shaped base material 11 is provided, and an intermediate layer 12, an oxide superconducting layer 13 and a protective layer 14 are sequentially deposited on one surface 11a of the base material 11. In the embodiment, the direction in which the layers such as the base material 11, the intermediate layer 12, the oxide superconducting layer 13, the protective layer 14, and the like are deposited is a thickness direction. In addition, a widthwise direction is a direction perpendicular to a longitudinal direction and the thickness direction. Side surfaces 16b of the superconducting laminated body 16 are side surfaces (one or both of the side surfaces) in the widthwise direction.

The base material 11 is a tape-shaped metal base material, and has major surfaces (the one surface 11a and a back surface 11b opposite thereto) perpendicular to the thickness direction. As a specified example of a metal that constitutes the base material 11, a nickel alloy represented by Hastelloy (Trademark), stainless steel, an oriented Ni-W alloy in which an aggregate structure is introduced into a nickel alloy, or the like is exemplified. The thickness of the base material 11 may be appropriately adjusted for any purpose, for example, to 10 to 500 µm. A metal thin film 15 formed of Ag, Cu, or the like may be formed at the back surface 11b, a side surface 11c of the base material 11, or both surfaces thereof to improve bondability by sputtering or the like. In addition, the metal thin film 15 (a second protective layer) may be integrated with the protective layer 14 formed on a surface of the oxide superconducting layer 13.

The intermediate layer 12 is formed between the base material 11 and the oxide superconducting layer 13. The intermediate layer 12 may have a multi-layer configuration, and, for example, may have an anti-diffusion layer, a bed layer, an oriented layer, a cap layer, and the like in sequence from the base material 11 toward the oxide superconducting layer 13. The layers are not limited to being formed one by one but some layers may be omitted or the same layer may be deposited repeatedly in two layers or more.

The anti-diffusion layer has a function of suppressing some elements of the base material 11 from being diffused and from being mixed with the oxide superconducting layer 13 as impurities. The anti-diffusion layer includes, for example, Si₃N₄, Al₂O₃, GZO (Gd₂Zr₂O₇), or the like. The thickness of the anti-diffusion layer is, for example, 10 to 400 nm.

The bed layer is used to reduce a reaction on an interface between the base material 11 and the oxide superconducting layer 13, and improve orientation of the layer formed on the bed layer. As a material of the bed layer, for example, Y₂O₃, Er₂O₃, CeO₂, Dy₂O₃, Eu₂O₃, Ho₂O₃, La₂O₃, or the like are exemplary examples. The thickness of the bed layer is, for example, 10 to 100 nm.

The oriented layer is formed of a material that is oriented along two axes to control crystalline orientation of the cap layer thereon. As a material of the oriented layer, for example, a metal oxide such as Gd₂Zr₂O₇, MgO, ZrO₂-Y₂O₃ (YSZ), SrTiO₃, CeO₂, Y₂O₃, Al₂O₃, Gd₂O₃, Zr₂O₃, Ho₂O₃, Nd₂O₃, or the like may be exemplified. The oriented layer is preferably formed by an ion-beam-assisted deposition (IBAD) method.

The cap layer is formed on the surface of the above-mentioned oriented layer and formed of a material in which crystal grains can be self-oriented in an in-plane direction. As a material of the cap layer, for example, CeO₂, Y₂O₃, Al₂O₃, Gd₂O₃, ZrO₂, YSZ, Ho₂O₃, Nd₂O₃, LaMnO₃, or the like are exemplary examples. The thickness of the cap layer is, for example, 50 to 5000 nm.

The oxide superconducting layer 13 has an oxide superconducting body. While the oxide superconducting body is not particularly limited, and a rare-earth-based oxide superconducting body represented by a general formula REBa₂Cu₃O_{X} (RE123) is an exemplary example. As a rare earth element RE, exemplary examples include one or two or more kinds of Sc, Y, La, Ce, Pr, Nd, Pm, Sm, Eu, Gd, Tb, Dy, Ho, Er, Tm, Yb and Lu. Among these, one or a combination of two or more of Y, Gd, Eu and Sm may be preferable. The thickness of the superconducting layer is, for example, about 0.5 to 5 µm. The thickness is preferably uniform in the longitudinal direction.

The protective layer 14 has a function of bypassing overcurrent that occurs in an accident, which suppresses the occurrence of a chemical reaction between the oxide superconducting layer 13 and the layer formed on the protective layer 14, or the like. As a material of the protective layer 14, exemplary examples include silver (Ag), copper (Cu), gold (Au), an alloy of gold and silver, another silver alloy, a copper alloy, a gold alloy, and the like. The protective layer 14 covers a surface of at least the oxide superconducting layer 13 (in the thickness direction, a surface opposite to the base material 11). Further, the protective layer 14 may cover a portion or all of a region selected from the side surfaces of the oxide superconducting layer 13, the side surfaces of the intermediate layer 12, and the side surface 11c and the back surface 11b of the base material 11.

The stabilizer 17 is constituted by a metal tape having a cross-sectional shape bent in the widthwise direction from the outer surface of the layer deposited on the one surface 11a of the base material 11 (for example, the protective layer 14 on the oxide superconducting layer 13) around the superconducting laminated body 16. Accordingly, since the side surfaces of the oxide superconducting layer 13 can be stably covered, the water resistance of the superconducting wire 10 can be improved. The material used in the stabilizer 17 may differ according to the use of the superconducting wire 10. For example, when the metal is used in a superconducting cable, a superconducting motor, or the like, since the material should have a function as a main section of the bypass configured to commutate the overcurrent generation upon conversion to the normal conducting state, a metal having good electro-conductivity is appropriately used. As the metal having good electro-conductivity, a metal such as copper, a copper alloy, aluminum, an aluminum alloy, or the like are exemplary examples. In addition, when the superconducting wire is used in a superconducting fault current limiter, since there is a need to instantly suppress the overcurrent generated upon conversion into the normal conducting state, a high resistant metal is appropriately used. As the high resistance metal, for example, a Ni-based alloy such as Ni-Cr or the like is an exemplary example. In addition, since exfoliation strength of the superconducting laminated body 16 is further improved, a metal tape formed of SUS or the like having strength greater than that of a Cu foil or the like may be used as the stabilizer 17.

In the embodiment, in the superconducting laminated body 16, the stabilizer 17 includes a first portion 17a configured to cover an outer surface of the layer (in FIG. 1, the surface of the protective layer 14) deposited on the one surface 11a of the base material 11, a second portion 17b configured to cover the side surface 16b of the superconducting laminated body 16, and a third portion 17c configured to cover a side edge of the back surface 11b of the base material (or the surface of the metal thin film 15 or the like formed thereon). The metal tape that constitutes the stabilizer 17 may have the second portion 17b and the third portion 17c at both sides in the widthwise direction of the first portion 17a in sequence. The third portion 17c may be constituted by both end portions of the metal tape to cover both end portions in the widthwise direction of the back surface 11b of the base material. The third portion 17c may further extend from both side edges of the base material 11 toward a central section in the widthwise direction on the back surface 11b of the base material 11. The first portion 17a and the third portion 17c are preferably substantially flat, and the first portion 17a and the third portion 17c may be parallel to each other.

The stabilizer 17 is bonded to the superconducting laminated body 16 by the bonding material 18. For example, a bonding material may be provided between the first portion 17a of the stabilizer 17 and the protective layer 14, between the second portion 17b of the stabilizer 17 and the side surface 16b of the superconducting laminated body 16, and between the third portion 17c of the stabilizer 17 and the back surface 11b of the base material (or the surface of the metal thin film 15 or the like formed thereon).

The bonding material 18 is filled between the side surface 16b of the superconducting laminated body 16 and the second portion 17b of the stabilizer 17. The bonding material 18 is preferably cover an interface between at least the oxide superconducting layer 13 and an adjacent layer thereof (the intermediate layer 12 or the protective layer 14) on the side surface 16b of the superconducting laminated body 16. The entirety of the oxide superconducting layer 13 and the adjacent layer thereof are preferably covered with the bonding material 18, and further, the entire side surface 16b of the superconducting laminated body 16 is preferably covered with the bonding material 18.

When a thickness of the bonding material 18 that covers the side surface 16b of the superconducting laminated body 16 is increased, since the bonding material 18 filled between the side surface 16b and the stabilizer 17 can be easily adhered to the side surface 16b even when there is a concavo-convex portion on the side surface 16b of the superconducting laminated body 16, is a layer formed of a single material throughout the thickness of the superconducting laminated body 16 and does not have a weak interface therein, strength of the end portions in the widthwise direction of the superconducting wire 10 can be increased. In addition, starting points of the interlayer exfoliation of the superconducting laminated body 16 are not easily generated, and the exfoliation strength can be improved. For example, when a strong external force is applied to the superconducting wire due to an electromagnetic force upon electric connection, thermal contraction of an insulating material (resin) or the like around the wire, a residual stress, or the like, even if stress is concentrated on the end portion rather than the central portion in the widthwise direction, exfoliation between the layers that constitute the superconducting wire can be suppressed.

The thickness of the bonding material 18 that covers the side surface 16b is preferably, for example, 5% or more, 10% or more or 20% or more of the width of the superconducting laminated body 16, 50% or more, 100% or more or 2 times or more the thickness of the superconducting laminated body 16, or 100 µm or more, 200 µm or more, 500 µm or more, or the like. The thickness of the bonding material 18 between the second portion 17b and the superconducting laminated body 16 is preferably larger than the thickness of the bonding material 18 between the first portion 17a and the superconducting laminated body 16.

As the bonding material that constitutes the bonding material 18, for example, Sn-Pb-based solders, Pb-Sn-Sb-based solders, Sn-Pb-Bi-based solders, Bi-Sn-based solders, Sn-Cu-based solders, Sn-Pb-Cu-based solders, Sn-Ag-based solders, and the like, and metals such as Sn, Sn alloys, In, In alloys, Zn, Zn alloys, Ga, Ga alloys, and the like are exemplary examples. An exemplary example of the melting point of the bonding material is, for example, 500 °C or less, or 300 °C or less.

As a method of forming the stabilizer 17 and the bonding material 18 around the superconducting laminated body 16, a method including a process of disposing the stabilizer 17 around the superconducting laminated body 16, a process of folding the stabilizer 17 along an exterior of the superconducting laminated body 16 (forming), a process of melting a portion of the entirety of the bonding material 18 by heating and pressurizing the superconducting laminated body 16 and the stabilizer 17 (remelting, reflow), and a process of solidifying the bonding material by cooling the entirety while continuing the pressurization are exemplary examples.

A supply method of the bonding material 18 is not limited thereto but the bonding material 18 may be previously attached to one or both of the superconducting laminated body 16 and the stabilizer 17 or a liquid or solid bonding material may be supplied between the superconducting laminated body 16 and the stabilizer 17. Two or more kinds of supply methods may be used in combination.

As a method of attaching the bonding material 18 to the superconducting laminated body 16 or the stabilizer 17, a method of sputtering a bonding material, a method of plating a bonding material (electroplating or the like), a method of using a molten bonding material (hot dipping or the like), a combination of two or more of those, and the like are exemplary examples.

As a type of the bonding material when a solid bonding material is supplied in a state in which the bonding material is separated from the superconducting laminated body 16 and the stabilizer 17, a sheet shape, a filamentous shape, a linear shape, a granular shape, a powder shape, a shape, a plate shape, a lump shape, a sphere shape, a columnar shape, and the like are exemplary examples.

The width of the metal tape prepared as the material of the stabilizer 17 is preferably smaller than an outer circumference of the superconducting laminated body 16. Accordingly, when the metal tape is formed to surround an outer circumference of the superconducting laminated body 16, since end portions of the metal tape in the widthwise direction do not overlap each other, the end portions of the stabilizer 17 cannot easily rise from the superconducting laminated body 16. A gap generated between the end portions in the widthwise direction of the metal tape is preferably closed by forming a closing section 19 through soldering, welding, or the like.

The closing section 19 may be formed of a bonding material filled in the area. The bonding material that fills the closing section 19 may be formed after bonding of the superconducting laminated body 16 and the stabilizer 17. In addition, the closing section 19 may also be constituted by the welded section. The welded section may include a material diffused from surrounding members upon welding, for example, a material such as the base material 11, the stabilizer 17, the bonding material 18, and the like. When the welded section is formed, a material such as a metal or the like may also be further supplied from the outside. The outer surface of the closing section 19 may protrude or be recessed from or may be flush with the outer surface of the stabilizer 17.

As a specific example of the forming, a process of folding both end portions in the widthwise direction of the metal tape toward the side surfaces of the superconducting laminated body and folding both end portions in the widthwise direction of the metal tape toward the back surface of the base material using a forming roll or the like after the superconducting laminated body is disposed on the flat metal tape is an exemplary example. According to the forming, a product in which the same cross-sectional shape continues in the longitudinal direction of the superconducting wire can be efficiently manufactured.

When the stabilizer 17 shown in FIG. 1 is formed, first, the stabilizer 17 can be folded between the first portion 17a in which the stabilizer 17 covers the one surface of the superconducting laminated body 16 in the thickness direction and the second portion 17b in which the stabilizer 17 covers the side surface 16b of the superconducting laminated body 16, and then the stabilizer 17 can be folded between the second portion 17b and the third portion 17c. As the width of the first portion 17a is increased to be larger than the width of the superconducting laminated body 16 using a molding jig, a thickness of the bonding material 18 that covers the side surface 16b of the superconducting laminated body 16 can be increased.

Before the superconducting laminated body is disposed on the metal tape, a portion or the entirety of a predetermined folding angle may also be previously folded at a predetermined place of the metal tape. In this case, the folding angle is smaller than a right angle and a gap between the end portions in the widthwise direction of the metal tape is preferably increased between the second portion to cover the side surface of the superconducting laminated body and the third portion to cover the back surface of the base material before insertion such that the superconducting laminated body can be easily inserted into the folded metal tape.

In the molding jig (the molding apparatus) shown in FIG. 2, a receptacle table 31 has a groove 32 having a width larger than that of the superconducting laminated body 16. As the stabilizer 17 is folded along the inner surface of the groove 32 shown in the drawings, the first portion 17a of the stabilizer 17 may be formed to have a width larger than that of the superconducting laminated body 16. When the stabilizer 17 is molding-processed, if the superconducting laminated body 16 is disposed on the stabilizer 17 (the position of the first portion 17a) and pressurized by a pressing member 33 from above the superconducting laminated body 16, the stabilizer 17 can be easily formed. As the pressing member 33, a roller or the like that enables continuous machining in the longitudinal direction is preferable, and as other example a bar, a plate, and the like are exemplary.

An enclosure 34 may also be inserted between the side surface 16b of the superconducting laminated body 16 and the second portion 17b of the stabilizer 17. The enclosure 34 serving as a portion of the molding jig may also be a structure protruding from the pressing member 33, a member separated from the pressing member 33, or the like. For example, an edge portion protruding from the end portion in the widthwise direction of the pressing roller may be the enclosure 34. In addition, the enclosure 34 may also be a solid bonding material supplied between the superconducting laminated body 16 and the stabilizer 17.

In manufacture of the superconducting coil using the tape-shaped superconducting wire 10, after the superconducting wire 10 is wound along an outer circumferential surface of a bobbin in a required number of layers to form a coil shape (a multi-layer winding coil), a resin such as an epoxy resin or the like can be impregnated to cover the wound superconducting wire 10 to fix the superconducting wire 10. When the superconducting wire 10 is wound in a coil shape, mainly, the thickness direction of the superconducting wire 10 may be a radial direction of the coil. Whether either of the base material 11 side (a back side) and the protective layer 14 side (a face side) in the superconducting laminated body 16 is on the winding center side of the coil is not limited.

The widthwise direction of the superconducting wire 10 is substantially parallel to a central axis of the coil, and mainly, the face side and the back side of the superconducting wire 10 (according to circumstances, the face sides or the back sides) face each other between neighboring loops of the coil. Then, the resin (the impregnated resin) is filled between the superconducting wires 10 which face each other and the superconducting wires 10 are adhered to each other. Further, it is also possible to change the orientation of the superconducting wire 10 in the coil by locally twisting or folding the superconducting wire 10 and providing the connecting section or the like.

In the present embodiment, since the stabilizer is formed of one metal tape to have a curved cross-sectional shape, durability can be increased and manufacturing cost can also be reduced.

While the present invention has been described on the basis of the preferred embodiment above, the present invention is not limited to the above-mentioned embodiment but various modifications may be made without departing from the spirit of the present invention.

A metal layer may also be formed on the outer surface of the stabilizer by soldering, plating, or the like.

Two or more means and methods used in molding of the stabilizer may be combined.

The superconducting wire may have an external terminal. A place of the wire having the external terminal may have a cross-sectional structure different from another place.

### EXAMPLES

Further, examples of the embodiment will be described specifically. Further, the present invention is not limited only to these examples.

A manufacturing example of the superconducting wire 10 shown in FIG. 1 is provided.
(1) A Cu foil is prepared as the stabilizer 17, and a Sn layer (a bonding material) is formed on one surface of the Cu foil by plating or the like.
(2) The protective layer 14 of the oxide superconducting layer 13 of the superconducting laminated body 16 faces the Sn layer of the Cu foil, and bonding (soldering) is performed.
(3) The stabilizer 17 is folded by 90°, and a clearance of 10% or more of the width of the superconducting laminated body 16 is formed between the side surface 16b of the superconducting laminated body 16 and the second portion 17b of the stabilizer 17. According to necessity, a bonding material such as Sn, solder, or the like may also be supplied between the superconducting laminated body 16 and the stabilizer 17.
(4) The stabilizer 17 is formed such that the stabilizer 17 further folds the superconducting laminated body 16 and encloses the superconducting laminated body 16.
(5) The superconducting laminated body 16 and the stabilizer 17 are bonded (soldered) at the back side in the thickness direction.

According to the examples, in the superconducting wire 10, since the thick bonding material is adhered to the end portion in the widthwise direction of the superconducting laminated body 16 and the side surface 16b of the superconducting laminated body 16 is covered, exfoliation strength of the superconducting laminated body 16 can be improved and interlayer exfoliation can be suppressed.

### DESCRIPTION OF THE REFERENCE SYMBOLS

10 Superconducting wire
11 Base material
11 a One surface
11b Base material back surface
12 Intermediate layer
13 Oxide superconducting layer
14 Protective layer
15 Metal thin film (second protective layer)
16 Superconducting laminated body
17 Stabilizer
17a First portion
17b Second portion
17c Third portion
18 Bonding material
19 Closing section
31 Receptacle table
32 Groove
33 Pressing member
34 Enclosure

## Claims

1. A method of manufacturing an oxide superconducting wire, the method comprising:
preparing a superconducting laminated body in which an intermediate layer and an oxide superconducting layer are sequentially deposited on a first surface of a tape-shaped base material and a protective layer configured to cover a surface of at least the oxide superconducting layer is formed;
folding a tape-shaped stabilizer, dividing the stabilizer into a first portion in which the stabilizer covers one surface of the superconducting laminated body in a thickness direction and a second portion in which the stabilizer covers both side surfaces of the superconducting laminated body in a widthwise direction, and disposing the stabilizer around the superconducting laminated body;
increasing a width of the first portion to be larger than a width of the superconducting laminated body using a molding jig to cover the superconducting laminated body with the stabilizer; and
bonding the superconducting laminated body and the stabilizer and forming a bonding material between the second portion and the superconducting laminated body to have a thickness larger than that of a bonding material between the first portion and the superconducting laminated body.

2. The method of manufacturing the superconducting wire according to claim 1, wherein the molding jig has a groove having a width larger than that of the superconducting laminated body, and folds the stabilizer along an inner surface of the groove.

3. The method of manufacturing the oxide superconducting wire according to claim 1 or 2, wherein the molding jig has an area inserted between the side surface of the superconducting laminated body in the widthwise direction and the second portion of the stabilizer such that the width of the first portion is larger than that of the superconducting laminated body.

4. The method of manufacturing the oxide superconducting wire according to any one of claims 1 to 3, wherein, when the superconducting laminated body is covered with the stabilizer, a solid bonding material is disposed between the superconducting laminated body and the stabilizer.

5. The method of manufacturing the oxide superconducting wire according to claim 4, wherein at least some of the solid bonding material is supplied between the superconducting laminated body and the stabilizer in a state in which the bonding material is separated from the superconducting laminated body and the stabilizer.

6. A method of manufacturing a superconducting coil, the method comprising:
manufacturing an oxide superconducting wire through the method of manufacturing the oxide superconducting wire according to any one of claims 1 to 5; and
manufacturing a superconducting coil using the oxide superconducting wire.
